# EUROPEAN PATENT APPLICATION

(11) **EP 4 589 805 A1**
(43) Date of publication of application: **23.07.2025**
(21) Application number: 24199881.4
(22) Date of filing: 11.09.2024
(51) Int. Cl.: H02J 9/06

(54) **METHOD, APPARATUS AND CONTROLLER FOR FAULT DETECTION OF UNINTERRUPTIBLE POWER SUPPLY**

(30) Priority: 17.01.2024 CN 202410066888
(71) Applicant: Vertiv Tech Co., Ltd., Guangdong 518055 (CN)
(72) Inventor: XU, Wei, 518055 Shenzhen (CN); WU, Feng, 518055 Shenzhen (CN); CHEN, Peng, 518055 Shenzhen (CN)
(74) Representative: Morrall, Jonathan Ian McLachlan

(57) **Abstract**

Provided in the present disclosure are a method, an apparatus and a controller for fault detection of an uninterruptible power supply. A second terminal of a mains power switch device in the uninterruptible power supply is electrically connected to a corresponding battery switch device. Before the mains power switch device is closed, a comparison is made, by the controller, between the voltage value of the second terminal of the mains power switch device and the voltage value of the battery positive access terminal/battery negative access terminal associated with the mains power switch device. In a case where the absolute value of the difference between the two voltages is less than or equal to the first preset voltage difference, it is determined that the absolute value of the originally large voltage difference is reduced due to a failure of the battery switch device. Thereby, the battery switch device which is faulty is determined, so that the device can be repaired or replaced, to avoid damage to the uninterruptible power supply when the mains power switch device is closed. Since the voltage value of the battery access terminal is provided by the external battery or the charger capacitor, regardless of whether the external battery is connected to the uninterruptible power supply or not, the two battery access terminals can always be maintained at an appropriate voltage value, so that a smooth implementation of the detection is ensured.

## Description

This application claims the benefit and priority of Chinese Application No.2024100 66888.2, filed on January 17, 2024, the entire disclosure of which is incorporated herein by reference.

### FIELD

The present disclosure relates to the field of uninterruptible power supplies, and in particular, to a method, an apparatus and a controller for fault detection of an uninterruptible power supply.

### BACKGROUND

An uninterruptible power supply (UPS) is an apparatus in a data center that provides stable power to post-stage apparatuses. The UPS includes a battery pack, a rectification and discharge multiplexing device, an inverter device and a switching device. The switching device is electrically connected to the battery pack and the rectification and discharge multiplexing device. When the UPS is running in a battery mode, the switching device is configured to supply power stored in a battery through the rectification and discharge multiplexing device and the inverter device to power a load, in order to improve a device utilization.

The switching device generally includes multiple battery switch devices. The multiple battery switch devices are connected in series between an input terminal of the rectification and discharge multiplexing device and a terminal of the battery. In a case where any one of the battery switch devices is short-circuited and a mains power switch device electrically connected to the battery switch device and disposed between the input terminal of the rectification and discharge multiplexing device and the mains power is turned on, a short-circuit loop is formed between the battery and the mains power. The short-circuit loop passes through a bus capacitor. A superposition of a battery voltage and a mains voltage result in a short-circuit voltage which far exceeds a rated value of the bus capacitor. Thereby, the bus capacitor fails, resulting in power loss of post-stage apparatuses of the UPS and a reduced reliability of the UPS.

### SUMMARY

The present disclosure provides a method, an apparatus and a controller for fault detection of an uninterruptible power supply, which are used to solve the technical problem of unstable operation of the uninterruptible power supply caused by a switching device failure.

In a first aspect, a method for fault detection of an uninterruptible power supply is provided in the present disclosure. The method is applied to an uninterruptible power supply. The uninterruptible power supply includes a battery switch device, a mains power switch device, and a charger capacitor. An input terminal of the uninterruptible power supply, the mains power switch device, and a first terminal of the battery switch device are electrically connected in series in sequence. A second terminal of the battery switch device is electrically connected to a battery positive access terminal or a battery negative access terminal of the uninterruptible power supply. The battery positive access terminal is coupled to a first terminal of the charger capacitor, and the battery negative access terminal is coupled to a second terminal of the charger capacitor.

The method includes:
acquiring a first voltage difference between a second terminal of the mains power switch device and a neutral line, before the mains power switch device is closed, wherein the second terminal of the mains power switch device is electrically connected to the first terminal of the battery switch device;
acquiring a second voltage difference between the battery positive access terminal and the neutral line when the second terminal of a battery switch device is electrically connected to the battery positive access terminal, wherein a voltage value of the battery positive access terminal is a voltage value of a positive electrode of a battery connected to the battery positive access terminal or a voltage value of the first terminal of the charger capacitor;
acquiring a second voltage difference between the battery negative access terminal and the neutral line when the second terminal of a battery switch device is electrically connected to the battery negative access terminal, wherein a voltage value of the battery negative access terminal is a voltage value of a negative electrode of a battery connected to the battery negative access terminal or a voltage value of the second terminal of the charger capacitor; and
determining that the battery switch device is faulty in a case where an absolute value of a difference between the first voltage difference and the second voltage difference is less than or equal to a first preset voltage difference.

Optionally, the uninterruptible power supply further includes a precharge circuit and a bus capacitor, and the input terminal of the uninterruptible power supply, the precharge circuit, the bus capacitor and the neutral line are electrically connected in series; and
before the acquiring a first voltage difference between a second terminal of the mains power switch device and a neutral line, the method further includes:
controlling the precharge circuit to be turned on, enabling the input terminal of the uninterruptible power supply to precharge the bus capacitor.

Optionally, the uninterruptible power supply further includes a battery charging circuit, a first charging switch device and a second charging switch device. The first charging switch device is electrically connected in series between the battery positive access terminal and the first terminal of the charger capacitor. The second charging switch device is electrically connected in series between the battery negative access terminal and the second terminal of the charger capacitor. The charger capacitor is electrically connected between a first terminal of the battery charging circuit and a second terminal of the battery charging circuit. The bus capacitor is electrically connected between a third terminal of the battery charging circuit and a fourth terminal of the battery charging circuit.

Before the acquiring a second voltage difference between the battery positive access terminal and the neutral line and the acquiring a second voltage difference between the battery negative access terminal and the neutral line, the method further includes:
acquiring a connection state of a battery, wherein the connection state includes a connected state or an unconnected state; and
controlling the battery charging circuit to charge the charger capacitor until a voltage difference between two terminals of the charger capacitor is equal to a third voltage difference, when the battery is in the unconnected state and the voltage difference between the two terminals of the charger capacitor is less than a second preset voltage difference, and turning on the first charging switch device and the second charging switch device after the charging is completed;
wherein the third voltage difference is greater than or equal to the second preset voltage difference.

Optionally, the third voltage difference is less than a third preset voltage difference, and the third preset voltage difference is determined based on a voltage of a bus across which the bus capacitor is connected.

Optionally, the acquiring a connection state of a battery includes:
acquiring a voltage difference between the battery positive access terminal and the battery negative access terminal after the uninterruptible power supply is powered on;
determining that the battery is in an unconnected state in a case where the voltage difference between the battery positive access terminal and the battery negative access terminal is less than the second preset voltage difference; and
determining that the battery is in a connected state in a case where the voltage difference between the battery positive access terminal and the battery negative access terminal is greater than or equal to the second preset voltage difference.

Optionally, the controlling the battery charging circuit to charge the voltage difference between two terminals of the charger capacitor to the third voltage difference includes:
charging the charger capacitor by the battery charging circuit using electricity stored in the bus capacitor.

Optionally, after acquiring the second voltage difference, the method further includes:
closing the mains power switch devices of the uninterruptible power supply when the absolute value of the difference between the first voltage difference and the second voltage difference corresponding to each battery switch device is greater than the first preset voltage difference, to control the uninterruptible power supply to operate.

In a second aspect, an apparatus for fault detection of an uninterruptible power supply is provided in the present disclosure. The apparatus includes an acquisition module and a processing module.

The acquisition module is configured to acquire a first voltage difference between a second terminal of a mains power switch device and a neutral line, before the mains power switch device is closed, where the mains power switch device is located in an uninterruptible power supply, the uninterruptible power supply further includes a battery switch device and a charger capacitor, an input terminal of the uninterruptible power supply is electrically connected to a first terminal of the mains power switch device, a second terminal of the mains power switch device is electrically connected to the battery switch device, a second terminal of the battery switch device is electrically connected to a battery positive access terminal or a battery negative access terminal of the uninterruptible power supply, the battery positive access terminal is coupled to a first terminal of the charger capacitor, and the battery negative access terminal is coupled to a second terminal of the charger capacitor;

The acquisition module is further configured to acquire a second voltage difference between the battery positive access terminal and the neutral line when the second terminal of the battery switch device is electrically connected to the battery positive access terminal, wherein a voltage value of the battery positive access terminal is a voltage value of a positive electrode of a battery connected to the battery positive access terminal or a voltage value of the first terminal of the charger capacitor;

The acquisition module is further configured to acquire a second voltage difference between the battery negative access terminal and the neutral line when the second terminal of the battery switch device is electrically connected to the battery negative access terminal, wherein a voltage value of the battery negative access terminal is a voltage value of a negative electrode of a battery connected to the battery negative access terminal or a voltage value of the second terminal of the charger capacitor.

The processing module is configured to determine that the battery switch device is faulty in a case where an absolute value of a difference between the first voltage difference and the second voltage difference is less than or equal to a first preset voltage difference.

Optionally, the processing module is further configured to control the precharge circuit to be turned on before the first voltage difference between the second terminal of the mains power switch device and the neutral line is acquired by the acquisition module, enabling the input terminal of the uninterruptible power supply to precharge the bus capacitor.

The uninterruptible power supply further includes a precharge circuit and a bus capacitor, and the input terminal of the uninterruptible power supply, the precharge circuit, the bus capacitor and the neutral line are electrically connected in series.

In a third aspect, a controller is provided in the present disclosure. The controller includes a processor and a memory communicatively connected to the processor;
wherein the memory stores computer executable instructions; and
the processor, when executing the computer executable instructions, is configured to implement any one of the methods described in the first aspect.

A method, an apparatus and a controller for fault detection of an uninterruptible power supply are provided in the present disclosure. In an uninterruptible power supply using a rectification and discharge multiplexing converter, a battery switch device, a mains power switch device and a charger capacitor are provided. An input terminal of the uninterruptible power supply, the mains power switch device, and a first terminal of the battery switch device are electrically connected in series in sequence. A second terminal of the battery switch device is electrically connected to a battery positive access terminal or a battery negative access terminal of the uninterruptible power supply. The battery positive access terminal is coupled to a first terminal of the charger capacitor, and the battery negative access terminal is coupled to a second terminal of the charger capacitor. A first voltage difference between a second terminal of the mains power switch device connected to the battery switch device and a neutral line is acquired before the mains power switch device is closed. A second voltage difference between the battery positive access terminal and the neutral line is acquired when the battery switch device is electrically connected to the battery positive access terminal, and a second voltage difference between the battery negative access terminal and the neutral line is acquired when the battery switch device is electrically connected to the battery negative access terminal. In a case where an absolute value of a difference between the first voltage difference and the second voltage difference is less than or equal to a first preset voltage difference, it is determined that the battery switch device is faulty, so that repair is performed in time. In this way, damage to the uninterruptible power supply due to failure of the battery switch device is avoided and an operation stability of the uninterruptible power supply is ensured. Since the voltage value of the battery access terminal is provided by the external battery or the charger capacitor, regardless of whether the external battery is connected to the uninterruptible power supply or not, the two battery access terminals can always be maintained at an appropriate voltage value during the above detection process, so that a smooth implementation of the above detection is ensured.

### BRIEF DESCRIPTION OF THE DRAWINGS

Accompanying drawings here are incorporated in and constitute a part of this specification. The drawings illustrate embodiments consistent with the present disclosure and, together with the specification, are used to explain principles of the present disclosure.
Figure 1 is a schematic structural diagram of an uninterruptible power supply according to an exemplary embodiment of the present disclosure;
Figure 2A is a schematic structural diagram of an uninterruptible power supply according to another exemplary embodiment of the present disclosure;
Figure 2B is a schematic structural diagram of an uninterruptible power supply according to another exemplary embodiment of the present disclosure;
Figure 3 is a schematic flowchart of a method for fault detection of an uninterruptible power supply according to an exemplary embodiment of the present disclosure;
Figure 4 is a schematic flowchart of a method for fault detection of an uninterruptible power supply according to another exemplary embodiment of the present disclosure;
Figure 5 is a schematic flowchart of a method for fault detection of an uninterruptible power supply according to another exemplary embodiment of the present disclosure;
Figure 6 is a schematic oscillogram of a voltage on a second terminal of a corresponding mains power relay when a battery relay fails according to an exemplary embodiment of the present disclosure;
Figure 7 is a schematic structural diagram of an apparatus for fault detection of an uninterruptible power supply according to an exemplary embodiment of the present disclosure; and
Figure 8 is a schematic structural diagram of a controller according to an embodiment of the present disclosure.

Through the above-mentioned drawings, specific embodiments of the present disclosure are shown, which are described in further detail below. These drawings and textual descriptions are not intended to limit the scope of the concept of the present disclosure in any way, but are intended to illustrate the concepts of the present disclosure for those skilled in the art by referring to the specific embodiments.

### DETAILED DESCRIPTION

Exemplary embodiments are described in detail hereinafter, examples of which are illustrated in the accompanying drawings. When the following description refers to the drawings, the same numbers in different drawings refer to the same or similar elements, unless otherwise indicated. The embodiments described in the following exemplary embodiments do not represent all embodiments consistent with the present disclosure. On the contrary, they are merely examples of the apparatus and method consistent with aspects of the present disclosure as detailed in the appended claims.

A data center, commonly known as a computer room, includes a computer system, a communication system, a storage system, an environmental control apparatus, a monitoring apparatus and various safety devices. A stable power supply for a data center is a prerequisite for ensuring a stable operation of the data center. Therefore, an uninterruptible power supply is generally provided in the data center. The uninterruptible power supply is electrically connected between the mains power and power-consuming equipment in the data center, and is configured to provide a stable and continuous power supply to the power-consuming equipment.

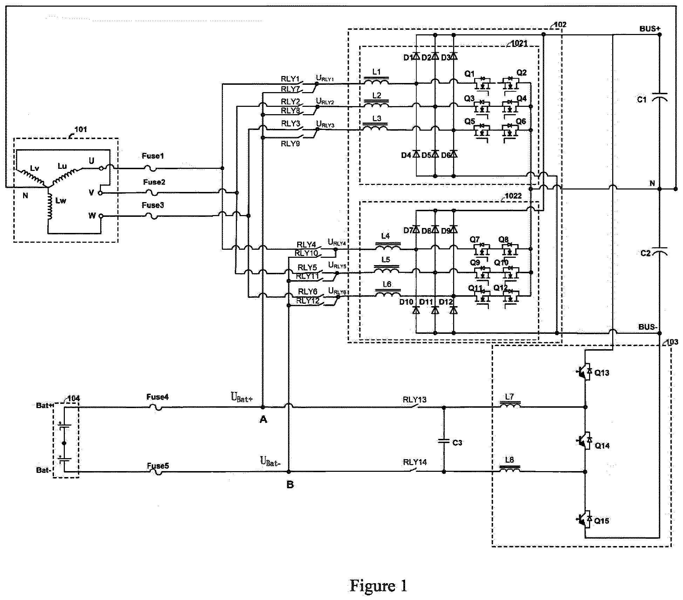

Figure 1 is a schematic diagram of a circuit configuration of an uninterruptible power supply according to an exemplary embodiment of the present disclosure. As shown in Figure 1, the uninterruptible power supply includes a UPS front-stage distribution transformer 101, a UPS rectification and discharge multiplexing conversion circuit, and a battery unit 104. The UPS rectification and discharge multiplexing conversion circuit includes a rectification and discharge multiplexing conversion unit 102, a battery charging circuit 103, multiple mains power relays RLY1 to RLY6, bus capacitors C1 and C2, a charger capacitor C3, charger relays RLY13 and RLY14, multiple fuses Fuse1 to Fuse5, multiple battery relays RLY7 to RLY12. The rectification and discharge multiplexing conversion unit 102 includes two rectification and discharge multiplexing conversion circuits 1021 and 1022.

The UPS front-stage distribution transformer 101 includes a Lu line, a Lv line, a Lw line, and a N line. The output terminals of the three-phase electricity are electrically connected to three of the fuses, Fuse1 to Fuse3, respectively. Each fuse is electrically connected to input terminals of the corresponding phases of the two rectification and discharge multiplexing conversion circuits 1021 and 1022. The corresponding mains power relays are connected in series between the fuses and the input terminals. The fuse Fuse1 located at a U-phase output terminal is electronically connected to the mains power relay RLY1 in the rectification and discharge multiplexing conversion circuit 1021 and the mains power relay RLY4 in the rectification and discharge multiplexing conversion circuit 1022. The fuse Fuse2 corresponding to a V-phase power is electrically connected to the mains power relays RLY2 and RLY5. The fuse Fuse3 corresponding to a W-phase power is electrically connected to the mains power relays RLY3 and RLY6.

The bus capacitor C1 is connected across two output terminals of the rectification and discharge multiplexing conversion circuit 1021. The bus capacitor C2 is connected across two output terminals of the rectification and discharge multiplexing conversion circuit 1022. The bus capacitor C1 has a first terminal connected to a bus BUS+, and a second terminal connected to a neutral line N. The bus capacitor C2 has a first terminal connected to the neutral line N, and a second terminal connected to a bus BUS-.

The bus is electrically connected to two input terminals of the battery charging circuit 103. An output terminal of the battery charging circuit 103 is connected in series with the charger relay RLY13 and the fuse Fuse4, and then is electrically connected to a positive electrode of the battery unit 104. Another output terminal of the battery charger 103 is connected in series with the charger relay RLY14 and the fuse Fuse5, and is then electrically connected to a negative electrode of the battery unit 104.

The battery charging circuit 103 includes multiple transistors. Each of the transistors is connected in anti-parallel with a freewheeling diode. In the transistor, an output terminal electrically connected to the bus BUS- is electrically connected to a positive electrode of the freewheeling diode, and an input terminal electrically connected to the charger relay RLY14 is electrically connected to a negative electrode of the freewheeling diode.

The fuse Fuse4 and the charger relay RLY13 are electrically connected at a point A, and the point A is coupled to a second terminal of the three mains power relays in the rectification and discharge multiplexing conversion circuit 1021. A first terminal of a mains power relay is coupled to a corresponding fuse. A battery relay is connected in series between the point A and a second terminal of each mains power relay respectively. The battery relay RLY7 is connected in series between the point A and the mains power relay RLY1. The battery relay RLY8 is connected in series between the point A and the mains power relay RLY2. The battery relay RLY9 is connected in series between the point A and the mains power relay RLY3.

The fuse Fuse5 and the charger relay RLY14 are electrically connected at a point B, and the point B is coupled to a second terminal of the three mains power relays in the rectification and discharge multiplexing conversion circuit 1022. A first terminal of a mains power relay is coupled to a corresponding fuse. A battery relay is connected in series between the point B and a second terminal of each mains power relay respectively. The battery relay RLY10 is connected in series between the point B and the mains power relay RLY4. The battery relay RLY11 is connected in series between the point B and the mains power relay RLY5. The battery relay RLY12 is connected in series between the point B and the mains power relay RLY6.

Based on the above circuit connection of the uninterruptible power supply, it can be known that when at least one battery relay is short-circuited, after the mains power relay electrically connected to the battery relay is powered on, a short-circuit loop is formed between the battery and the mains power (for example: when battery relay RLY7 is short-circuited, after the mains power relay RLY1 is powered on, a short-circuit loop includes in sequence: the positive electrode Bat+ of the battery, the fuse Fuse4, the battery relay RLY7, the mains power relay RLY1, the fuse Fuse1, the U-phase power, the neutral line N, the bus capacitor C2, the freewheeling diode in anti-parallel connection with the transistor Q15, the inductor L8, the charger relay RLY14, the fuse Fuse5, and the negative electrode Bat- of the battery). A voltage value of the short-circuit loop is a superimposition of the battery voltage and the one-phase voltage of the mains power. The superimposed voltage acts on the bus capacitor, and far exceeds a rated value of the bus capacitor. Therefore, the bus capacitor fails, resulting in power loss of post-stage apparatuses of the UPS and a reduced reliability of the UPS.

To solve the above problem, a method and an apparatus and a controller for fault detection of an uninterruptible power supply are provided in the present disclosure. The technical concept of the present disclosure is described here. In an uninterruptible power supply using a rectification and discharge multiplexing converter, a battery switch device, a mains power switch device and a charger capacitor are provided. An input terminal of the uninterruptible power supply, the mains power switch device, and a first terminal of the battery switch device are electrically connected in series in sequence. A second terminal of the battery switch device is electrically connected to a battery positive access terminal or a battery negative access terminal of the uninterruptible power supply. The battery positive access terminal is coupled to a first terminal of the charger capacitor, and the battery negative access terminal is coupled to a second terminal of the charger capacitor. A first voltage difference between a second terminal of the mains power switch device connected to the battery switch device and a neutral line is acquired before the mains power switch device is closed. A second voltage difference between the battery positive access terminal and the neutral line is acquired when the battery switch device is electrically connected to the battery positive access terminal, and a second voltage difference between the battery negative access terminal and the neutral line is acquired when the battery switch device is electrically connected to the battery negative access terminal. In a case where an absolute value of a difference between the first voltage difference and the second voltage difference is less than or equal to a first preset voltage difference, it is determined that the battery switch device is faulty, so that repair is performed in time. In this way, damage to the uninterruptible power supply due to failure of the battery switch device is avoided and an operation stability of the uninterruptible power supply is ensured. Since the voltage value of the battery access terminal is provided by the external battery or the charger capacitor, regardless of whether the external battery is connected to the uninterruptible power supply or not, the two battery access terminals can always be maintained at an appropriate voltage value during the above detection process, so that a smooth implementation of the above detection is ensured.

The technical solution of the present disclosure is described in detail below with specific embodiments. The following specific embodiments may be combined with each other, and the same or similar concepts or processes may not be repeated in some embodiments.

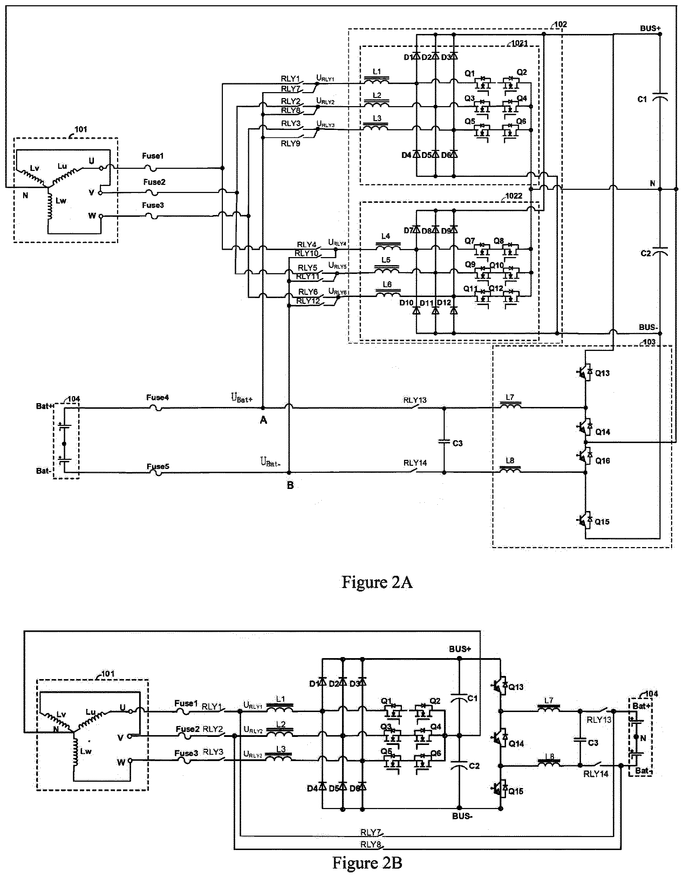

A circuit structure of the uninterruptible power supply is explained first. The method for fault detection of an uninterruptible power supply provided in the present disclosure is applicable to an uninterruptible power supply using a rectification and discharge multiplexing converter. That is, a switch device is connected in series between a battery and an input terminal of a rectifier circuit in the uninterruptible power supply. In addition to the uninterruptible power supply shown in Figure 1, variations of the circuit structure shown in Figure 1 may be provided. The variations include, but are not limited to: an uninterruptible power supply in which multiple parallel-connected UPS rectification and discharge multiplexing conversion circuits are electrically connected between the UPS front-stage distribution transformer 101 and the battery unit 104; an uninterruptible power supply including only one rectification and discharge multiplexing conversion circuit in the rectification and discharge multiplexing conversion unit 102; an uninterruptible circuit in which the Vienna topology in the rectification and discharge multiplexing conversion unit 102 shown in Figure 1 is replaced with a BOOST circuit; replacement of the battery charging circuit 103 shown in Figure 1 with a battery charging circuit with an N line (as shown in Figure 2A); an uninterruptible power supply in which the switch device is replaced with a contactor, a silicon controlled rectifier (SCR), an IGBT, an MOSFET or other switch devices; and an uninterruptible power supply in which at least one of the battery relays RLY7 to RLY9 is provided and at least one of the battery relays RLY10 to RLY12 is provided (for example, an uninterruptible power supply in which only the RLY7 and the RLY10 are provide).

For the uninterruptible power supply in which the rectification and discharge multiplexing conversion circuit unit 102 includes only one rectification and discharge multiplexing conversion circuit, there are at least two battery relays electrically connected between two mains power relays and the positive electrode BAT+ of the battery and the negative electrode BAT- of the battery, respectively. A circuit structure of an uninterruptible power supply is shown in Figure 2B, in which the battery relay RLY7 is electrically connected between a second terminal of the mains power relay RLY1 and the positive electrode BAT+ of the battery, and the battery relay RLY8 is electrically connected between a second terminal of the mains power relay RLY2 and the negative electrode BAT- of the battery. When any battery relay is short-circuited, there is a short-circuit between the battery and the distribution transformer. The short-circuit loop is similar to the aforementioned short-circuit loop, and is not repeated here.

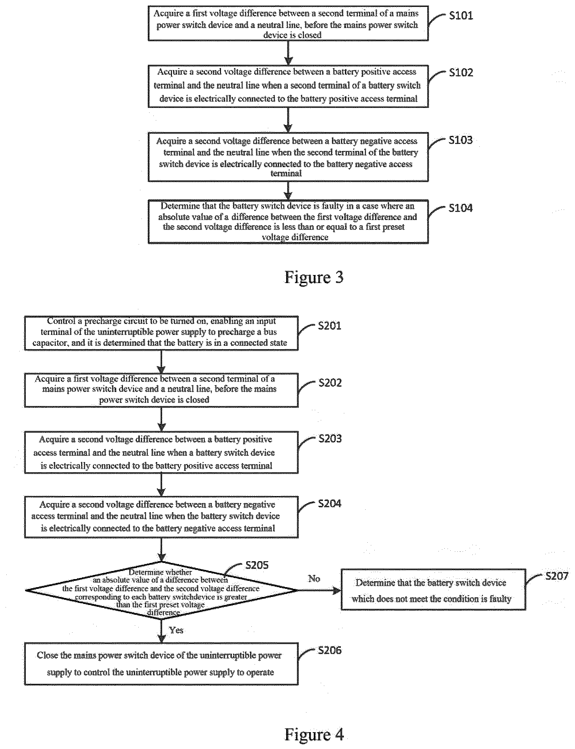

Figure 3 is a schematic flowchart of a method for fault detection of an uninterruptible power supply according to an exemplary embodiment of the present disclosure. The method is applied to an uninterruptible power supply including a rectification and discharge multiplexing converter. The method includes S101 to S104.

In S101, a first voltage difference between a second terminal of a mains power switch device and a neutral line is acquired before the mains power switch device is closed.

A first terminal of the mains power switch device is electrically connected to a distribution transformer, and the second terminal of the mains power switch device is electrically connected to a first terminal of the battery switch device. A second terminal of the battery switch device is electrically connected to a battery positive access terminal/battery negative access terminal.

The uninterruptible power supply includes a charger capacitor. The battery positive access terminal is coupled to a positive electrode of an external battery, and is coupled to a first terminal of the charger capacitor. The battery negative access terminal is coupled to a negative electrode of the external battery, and is coupled to a second terminal of the charger capacitor.

When the external battery is connected to the uninterruptible power supply, the battery positive access terminal is electrically connected to the positive electrode of the external battery, and the battery negative access terminal is electrically connected to the negative electrode of the external battery. A voltage value of the battery positive access terminal is the same as a voltage value of the positive electrode of the external battery. A voltage value of the battery negative access terminal is the same as a voltage value of the negative electrode of the external battery. When the external battery is not connected to the uninterruptible power supply, the battery positive access terminal is electrically coupled to the first terminal of the charger capacitor, and the battery negative access terminal is coupled to the second terminal of the charger capacitor. When a circuit between the battery positive access terminal and the first terminal of the charger capacitor is turned on, the voltage value of the battery positive access terminal is determined based on the voltage value of the first terminal of the charger capacitor. When a circuit between the battery negative access terminal and the second terminal of the charger capacitor is turned on, the voltage value of the battery negative access terminal is determined based on the voltage value of the second terminal of the charger capacitor.

In some embodiments, when the circuit between the battery positive access terminal and the first terminal of the charger capacitor is turned on, the voltage value of the battery positive access terminal is the same as a voltage value of the first terminal of the charger capacitor; and when the circuit between the battery negative access terminal and the second terminal of the charger capacitor is turned on, the voltage value of the battery negative access terminal is the same as a voltage value of the second terminal of the charger capacitor.

In an embodiment, the mains power switch device and the battery switch device may be any of the following: a relay, a contactor, an SCR, an IGBT, and a MOSFET. Other switch devices are also possible, and are not specifically limited here.

Before the mains power switch device is closed, the second terminal of the mains power switch device is not connected to the distribution transformer. In this case, a voltage difference between the second terminal of the mains power switch device and the neutral line N is measured.

In S102, a second voltage difference between the battery positive access terminal and the neutral line is acquired when the second terminal of the battery switch device is electrically connected to the battery positive access terminal.

The battery positive access terminal refers to a terminal electrically connected to a positive electrode of a battery when the battery is connected to the uninterruptible power supply.

In S103, a second voltage difference between the battery negative access terminal and the neutral line is acquired when the second terminal of the battery switch device is electrically connected to the battery negative access terminal.

The battery negative access terminal refers to a terminal electrically connected to a negative electrode of a battery when the battery is connected to the uninterruptible power supply.

In S104, it is determined that the battery switch device is faulty in a case where an absolute value of a difference between the first voltage difference and the second voltage difference is less than or equal to a first preset voltage difference.

The battery switch device is disconnected in a case where the battery switch device is not faulty. In this case, since the loop between the mains power switch device and the bus capacitor is turned off, a potential value of the second terminal of the mains power switch device is not affected by a power supply device or power storage device (the external battery or the charger capacitor). Hence, the voltage of the mains power switch device relative to the neutral line does not exceed a preset voltage. The absolute value of the second voltage difference acquired in step S 102 or S 103 is much greater than the preset voltage. Therefore, in a case where the battery switch device is not faulty, the absolute value of the difference between the first voltage difference and the second voltage difference is greater than the first preset voltage difference.

The battery switch device is short-circuited when the battery switch device is faulty. Since the second terminal of the battery switch device is electrically connected to the battery positive access terminal/battery negative access terminal, a potential value of the first terminal of the battery switch device is adjusted to be the same as a potential value of the second terminal of the battery switch device as the battery switch device is short-circuited, that is, the absolute value of the difference between the potential value of the second terminal of the mains power switch device and the potential value of the first terminal of the battery switch device is a voltage difference which is less than or equal to the first preset voltage difference. The first preset voltage difference is determined based on a voltage drop generated on the circuit between the two terminals. Thereby, it is determined that the battery switch device is faulty from a fact that an absolute value of the difference between the first voltage difference measured in step S101 and the second voltage difference measured in step S 102 or S103 is less than or equal to the first preset voltage difference.

In an embodiment, when the voltage drop between the battery switch device and the mains power switch device is negligible, the first preset voltage difference is 0V.

In the above technical solution, before the mains power switch device is closed, a comparison is made between the voltage value of the second terminal of the mains power switch device and the voltage value of the battery positive access terminal/battery negative access terminal associated with the mains power switch device. In a case where the absolute value of the difference between the two voltages is less than or equal to the first preset voltage difference, it is determined that the absolute value of the originally large voltage difference is reduced due to a failure of the battery switch device. Thereby, the battery switch device which is faulty can be determined, so that the device can be repaired or replaced, to avoid damage to the uninterruptible power supply caused by the failure of the battery switch device after the mains power switch device is closed subsequently. Since the voltage value of the battery access terminal is provided by the external battery or the charger capacitor, regardless of whether the external battery is connected to the uninterruptible power supply or not, the two battery access terminals can always be maintained at an appropriate voltage value during the above detection process, so that a smooth implementation of the above detection is ensured.

In the fault detection of the uninterruptible power supply, there are two situations, i.e., a situation where the battery is connected and a situation where the battery is unconnected.

A flow chart of a method for fault detection of an uninterruptible power supply in a case where the battery is connected is shown in Figure 4. The method includes steps S201 to S207.

In S201, the precharge circuit is controlled to be turned on, enabling the input terminal of the uninterruptible power supply to precharge the bus capacitor, and it is determined that the battery is in a connected state.

The uninterruptible power supply further includes a precharge circuit and a bus capacitor, and the input terminal of the uninterruptible power supply, the precharge circuit, the bus capacitor and the neutral line are electrically connected in series.

The precharge circuit includes a rectifier circuit, a switch device and a current-limiting resistor connected across the bus and the three-phase power of the distribution transformer. The precharge circuit is a circuit for limiting the charge of the charge current to the bus capacitor connected across the bus before the mains power switch device is closed.

The precharge circuit is turned off when the mains power switch device is closed.

When the battery is in the connected state, the battery positive access terminal is electrically connected to the positive electrode of the battery, and the battery negative access terminal is electrically connected to the negative electrode of the battery. The connection state of the battery is determined by measuring a voltage value at the battery positive access terminal and a voltage value at the battery negative access terminal. It is determined that the battery is connected in a case where a voltage difference between the battery positive access terminal and the battery negative access terminal is greater than a second preset voltage difference. It is determined that the battery is unconnected in a case where the voltage difference between the two terminals is less than or equal to the second preset voltage difference.

A first charging switch device is electrically connected in series between the battery positive access terminal and the first terminal of the charger capacitor. A second charging switch device is electrically connected in series between the battery negative access terminal and the second terminal of the charger capacitor. In this case, the charging switch device electrically connected between the battery positive access terminal, the battery negative access terminal and the charger capacitor is turned off. The voltage value at two terminals of the charger capacitor does not affect the voltage value of the battery positive access terminal and the battery negative access terminal. In some embodiments, the charging switch device includes, but is not limited to, a charger relay, a contactor, an SCR, an IGBT, and an MOSFET.

In S202, a first voltage difference between a second terminal of a mains power switch device and a neutral line is acquired before the mains power switch device is closed.

In S203, a second voltage difference between the battery positive access terminal and the neutral line is acquired when the battery switch device is electrically connected to the battery positive access terminal.

The second voltage difference between the battery positive access terminal and the neutral line is equivalent to a voltage difference between the positive electrode of the battery and the neutral line.

In S204, a second voltage difference between the battery negative access terminal and the neutral line is acquired when the battery switch device is electrically connected to the battery negative access terminal.

The second voltage difference between the battery negative access terminal and the neutral line is equivalent to a voltage difference between the negative electrode of the battery and the neutral line.

An acquisition order of the first voltage difference and the second voltage difference is not specifically limited, and the order illustrated in the present disclosure is merely an example of acquiring the voltage differences.

In S205, it is determined whether the absolute value of the difference between the first voltage difference and the second voltage difference corresponding to each battery switch device is greater than the first preset voltage difference.

The method proceeds to step S206 in a case where the absolute values are greater than the first preset voltage difference; or otherwise, the method proceeds to step S207.

In S206, the mains power switch devices of the uninterruptible power supply are closed to control the uninterruptible power supply to operate.

As the absolute value of the difference between the first voltage difference and the second voltage difference corresponding to each battery switch device is greater than the first preset voltage difference, it is determined that each battery switch device is not faulty. Hence, the mains power switch devices of the uninterruptible power supply can be closed, to control the uninterruptible power supply to operate.

In S207, the battery switch device which does not meet the condition is determined faulty.

In a case where the absolute value of the difference between the first voltage difference and the second voltage difference corresponding to at least one battery switch device is less than or equal to the first preset voltage difference, it is determined that damage is to be caused to the bus capacitor after the mains power switch device is powered on. Hence, the battery switch device which is faulty is to be determined based on the absolute value of the difference, and such battery switch device is to be repaired or replaced. The mains power switch devices of the uninterruptible power supply are to be closed after confirming that the faulty is solved.

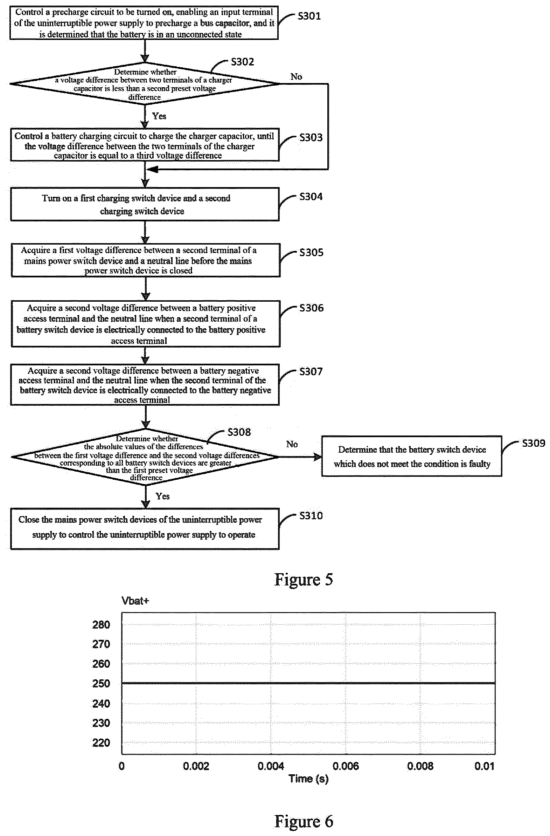

A flow chart of a method for fault detection of an uninterruptible power supply in a case where the battery is unconnected is shown in Figure 5. The method includes steps S301 to S310.

In S301, the precharge circuit is controlled to be turned on, enabling the input terminal of the uninterruptible power supply to precharge the bus capacitor, and it is determined that the battery is in an unconnected state.

This step is the same as S201 and is not repeated here.

In S302, it is determined whether a voltage difference between two terminals of the charger capacitor is less than a second preset voltage difference.

In a case where the voltage difference is less than the second preset voltage difference, the method proceeds to step S303 to charge the charger capacitor; or otherwise, the charging is not required and the method proceeds to step S304.

In S303, the battery charging circuit is controlled to charge the charger capacitor, until the voltage difference between the two terminals of the charger capacitor is equal to a third voltage difference.

The third voltage difference is greater than or equal to the second preset voltage difference and less than the third preset voltage difference. For example, the third voltage difference is greater than or equal to 400V and less than 700V The third preset voltage difference is determined based on the voltage of a bus across which the bus capacitor is connected and the battery charging circuit. The third preset voltage difference is less than the bus voltage.

During a process of charging the charger capacitor by the battery charging circuit, the first charging switch device connected in series between the first terminal of the charger capacitor and the battery positive access terminal is turned off, and the second charging switch device connected in series between the second terminal of the charger capacitor and the battery negative access terminal is turned off.

In S304, the first charging switch device and the second charging switch device are turned on.

After the first charging switch device and the second charging switch device are turned on, the charger capacitor may replace the external battery to provide a voltage to the second terminal of the battery switch device. Therefore, a subsequent potential comparison can still be performed when the battery is unconnected, to determine whether the battery switch device is faulty.

In S305, a first voltage difference between the second terminal of the mains power switch device and the neutral line is acquired before the mains power switch device is closed.

In S306, a second voltage difference between the battery positive access terminal and the neutral line is acquired when the second terminal of the battery switch device is electrically connected to the battery positive access terminal.

In S307, a second voltage difference between the battery negative access terminal and the neutral line is acquired when the second terminal of the battery switch device is electrically connected to the battery negative access terminal.

In S308, it is determined whether the absolute values of the differences between the first voltage difference and the second voltage differences corresponding to all the battery switch devices are greater than the first preset voltage difference.

The method proceeds to step S310 in a case where the absolute values are greater than the first preset voltage difference; or otherwise, the method proceeds to step S309.

In S309, the battery switch device which does not meet the condition is determined faulty.

In S310, the mains power switch devices of the uninterruptible power supply are closed to control the uninterruptible power supply to operate.

The method for fault detection provided in the present disclosure is explained below by taking the circuit structure shown in Figure 1 as an example.

Before the mains power relays RLY1 to RLY6 in the uninterruptible power supply are closed, it is determined that the battery is connected, and then the loop between a controller and the mains power is turned on. The controller operates, and controls the precharge loop to charge the bus capacitor. After the precharge is completed, voltages URLY1, URLY2, URLY3, URLY4, URLY5, URLY6 of second terminals (right endpoints) of the mains power relays RLY1, RLY2, RLY3, RLY4, RLY5, RLY6 relative to the N line, respectively, are acquired through a voltage measurement device. Voltage UBat+ and UBat- of the positive electrode and the negative electrode of the battery to the N line, respectively, are further measured.

A short circuit alarm of a battery relay needs to be issued in a case where: the absolute value of the difference between the voltage URLY1 at a back end of the mains power relay RLY1 relative to the N line and the positive port voltage UBat+ of the battery is less than or equal to the first preset voltage difference, and/or the absolute value of the difference between the voltage URLY2 at a back end of the mains power relay RLY2 relative to the N line and the positive port voltage UBat+ of the battery is less than or equal to the first preset voltage difference, and/or the absolute value of the difference between the voltage URLY3 at a back end of the mains power relay RLY3 relative to the N line and the positive port voltage UBat+ of the battery is less than or equal to the first preset voltage difference, and/or the absolute value of the difference between the voltage URLY4 at a back end of the mains power relay RLY4 relative to the N line and the negative port voltage UBat- of the battery is less than or equal to the first preset voltage difference, and/or the absolute value of the difference between the voltage URLY5 at a back end of the mains power relay RLY5 relative to the N line and the negative port voltage UBat- of the battery is less than or equal to the first preset voltage difference, and/or the absolute value of the difference between the voltage URLY6 at a back end of the mains power relay RLY6 relative to the N line and the negative port voltage UBat- of the battery is less than or equal to the first preset voltage difference.

More specifically, the battery relay RLY7 is alarmed for short circuit in a case where the absolute value of the difference between the voltage URLY1 at a back end of the mains power relay RLY1 relative to the N line and the positive port voltage UBat+ of the battery is less than or equal to the first preset voltage difference; the battery relay RLY8 is alarmed for short circuit in a case where the absolute value of the difference between the voltage URLY2 at a back end of the mains power relay RLY2 relative to the N line and the positive port voltage UBat+ of the battery is less than or equal to the first preset voltage difference; the battery relay RLY9 is alarmed for short circuit in a case where the absolute value of the difference between the voltage URLY3 at a back end of the mains power relay RLY3 relative to the N line and the positive port voltage UBat+ of the battery is less than or equal to the first preset voltage difference; the battery relay RLY10 is alarmed for short circuit in a case where the absolute value of the difference between the voltage URLY4 at a back end of the mains power relay RLY4 relative to the N line and the negative port voltage UBat- of the battery is less than or equal to the first preset voltage difference; the battery relay RLY11 is alarmed for short circuit in a case where the absolute value of the difference between the voltage URLY5 at a back end of the mains power relay RLY5 relative to the N line and the negative port voltage UBat- of the battery is less than or equal to the first preset voltage difference; the battery relay RLY12 is alarmed for short circuit in a case where the absolute value of the difference between the voltage URLY6 at a back end of the mains power relay RLY6 relative to the N line and the negative port voltage UBat- of the battery is less than or equal to the first preset voltage difference. With an accurate alarm, it is more convenient for maintenance personnel to repair, and it is prohibited to continue to close the mains power relays RLY1, RLY2, RLY3, RLY4, RLY5, and RLY6 and turn on the rectifier.

In order to facilitate understanding, illustration is provided with a simulation diagram (Figure 6) by taking the short circuit of the battery relay RLY9 as an example. Assuming that the battery voltage UBat is 500V, then UBat+= UBat-=250V. In a case where the battery relay is not short-circuited, the voltage waveform of the URLY3 is close to 0V. Once the battery relay RLY9 is short-circuited, the voltage waveform of the URLY3 becomes a waveform as shown in Figure 6. This waveform indicates that the voltage URLY3 of the back end of the mains power relay RLY3 relative to the N line is consistent with the positive port voltage Ubat+ of the battery.

In a case where the potential value at the back end of each of the above-mentioned mains power relays is not consistent with the corresponding port voltage of the battery, it is determined that none of the battery relays is short-circuited, and therefore the mains power relays RLY1, RLY2, RLY3, RLY4, RLY5, and RLY6 continue to be closed, and the module operates according to normal logics.

Before the mains power relays RLY1 to RLY6 in the uninterruptible power supply are closed, it is determined that the battery is unconnected, and then the loop between the controller and the mains power is turned on. The controller operates, and controls the precharge loop to charge the bus capacitor.

Before the mains power relays RLY1, RLY2, RLY3, RLY4, RLY5, and RLY6 are closed, the battery voltage Ubat, that is, a voltage difference between two terminals of the charger capacitor C3, is detected. In a case that the measured voltage UBat is less than 400V (a battery voltage currently adapted to the uninterruptible power supply is in a range of 400V to 700V, and therefore 400V is used as a distinguishing point, where the battery voltage may be dynamically adjusted according to the battery voltage adapted to the system), the charger relays RLY13 and RLY14 are turned off, the charger topology is turned on, and the charger capacitor C3 is charged to a voltage within the range of 400V to 700V, for example, 500V

The charger relays RLY13 and RLY14 are closed, and the detections of the voltages URLY1, URLY2, URLY3, URLY4, URLY5, and URLY6 of the back end of the mains power relays RLY1, RLY2, RLY3, RLY4, RLY5, and RLY6 relative to the N line, and the voltage UBat+ and the voltage UBat- of the positive electrode and the negative electrode of the battery to the N line are continued. The subsequent detection method is the same as the detection and determination method when the battery is connected, and is not repeated here.

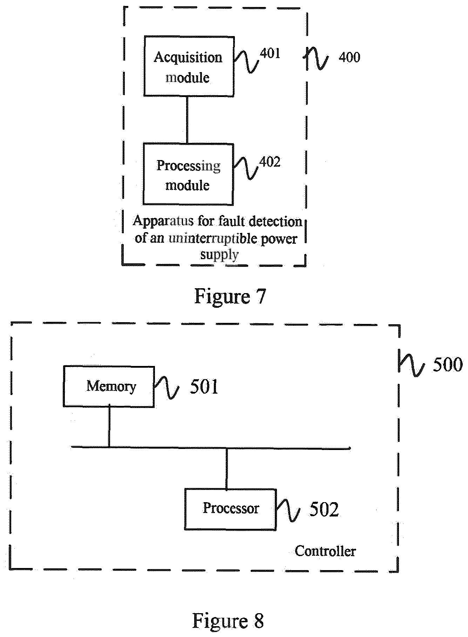

Figure 7 is a schematic structural diagram of an apparatus for fault detection of an uninterruptible power supply according to an exemplary embodiment of the present disclosure. The apparatus 400 for fault detection of an uninterruptible power supply includes an acquisition module 401 and a processing module 402.

The acquisition module 401 is configured to acquire a first voltage difference between a second terminal of a mains power switch device and a neutral line, before the mains power switch device is closed. The mains power switch device is located in an uninterruptible power supply. The uninterruptible power supply further includes a battery switch device and a charger capacitor. An input terminal of the uninterruptible power supply is electrically connected to a first terminal of the mains power switch device. A second terminal of the mains power switch device is electrically connected to the battery switch device. A second terminal of the battery switch device is electrically connected to a battery positive access terminal or a battery negative access terminal of the uninterruptible power supply. The battery positive access terminal is coupled to a first terminal of the charger capacitor, and the battery negative access terminal is coupled to a second terminal of the charger capacitor.

The acquisition module 401 is further configured to acquire a second voltage difference between the battery positive access terminal and the neutral line when the second terminal of the battery switch device is electrically connected to the battery positive access terminal, where a voltage value of the battery positive access terminal is a voltage value of the positive electrode of a battery connected to the battery positive access terminal or a voltage value of the first terminal of the charger capacitor.

The acquisition module 401 is further configured to acquire a second voltage difference between the battery negative access terminal and the neutral line when the second terminal of the battery switch device is electrically connected to the battery negative access terminal, where a voltage value of the battery negative access terminal is a voltage value of the negative electrode of a battery connected to the battery negative access terminal or a voltage value of the second terminal of the charger capacitor.

The processing module 402 is configured to determine that the battery switch device is faulty in a case where an absolute value of a difference between the first voltage difference and the second voltage difference is less than or equal to a first preset voltage difference.

In a possible embodiment, the processing module 402 is further configured to control the precharge circuit to be turned on before the first voltage difference between the second terminal of the mains power switch device and the neutral line is acquired by the acquisition module 401, enabling the input terminal of the uninterruptible power supply to precharge the bus capacitor.

The uninterruptible power supply further includes a precharge circuit and a bus capacitor, and the input terminal of the uninterruptible power supply, the precharge circuit, the bus capacitor and the neutral line are electrically connected in series.

In another possible embodiment, the acquisition module 401 is further configured to acquire a connection state of a battery, where the connection state includes a connected state or an unconnected state.

The processing module 402 is further configured to control, when the battery is in the unconnected state and the voltage difference between the two terminals of the charger capacitor is less than a second preset voltage difference, the battery charging circuit to charge the charger capacitor until a voltage difference between two terminals of the charger capacitor is equal to a third voltage difference, and turn on a first charging switch device and a second charging switch device after the charging is completed.

The uninterruptible power supply includes a battery charging circuit, a first charging switch device and a second charging switch device. The first charging switch device is electrically connected in series between the battery positive access terminal and the first terminal of the charger capacitor. The second charging switch device is electrically connected in series between the battery negative access terminal and the second terminal of the charger capacitor. The charger capacitor is electrically connected between a first terminal of the battery charging circuit and a second terminal of the battery charging circuit. The bus capacitor is electrically connected between a third terminal of the battery charging circuit and a fourth terminal of the battery charging circuit.

The third voltage difference is greater than or equal to the second preset voltage difference, and is less than a third preset voltage difference. The third preset voltage difference is determined based on a voltage of the bus across which the bus capacitor is connected.

In another possible embodiment, the processing module 402 is specifically configured to:
acquire a voltage difference between the battery positive access terminal and the battery negative access terminal after the uninterruptible power supply is powered on;
determine that the battery is in an unconnected state in a case where the voltage difference between the battery positive access terminal and the battery negative access terminal is less than the second preset voltage difference; and
determine that the battery is in a connected state in a case where the voltage difference between the battery positive access terminal and the battery negative access terminal is greater than or equal to the second preset voltage difference.

In another possible embodiment, the processing module 402 is specifically configured to control the battery charging circuit to charge the charger capacitor using electricity stored in the bus capacitor.

In another possible embodiment, the processing module 402 is further configured to close the mains power switch devices of the uninterruptible power supply when the absolute value of the difference between the first voltage difference and the second voltage differences corresponding to each battery switch device is greater than the first preset voltage difference, to control the uninterruptible power supply to operate.

Figure 8 is a schematic structural diagram of a controller according to an embodiment of the present disclosure. The controller 500 includes a memory 501 and a processor 502. The memory 501 is configured to store computer instructions executable by the processor. The memory 501 may include a high-speed random-access memory (RAM), and may further include a non-volatile memory (NVM), such as at least one disk memory, and the memory 501 may be a U disk, a mobile hard disk, a read-only memory, a magnetic disk, or an optical disk, or the like.

The processor 502, when executing the computer instructions, implements steps in the method for fault detection of an uninterruptible power supply with the controller as an execution subject in any of the above embodiments. For details, reference may be made to relevant descriptions in the foregoing method embodiments. The processor 502 may be a central processing unit (CPU), or may be other general-purpose processors, a digital signal processor (DSP), an application specific integrated circuit (ASIC), or the like. A general-purpose processor may be a microprocessor or any conventional processor. The steps of the method disclosed in conjunction with the present disclosure can be directly embodied and executed by a hardware processor, or be executed by a combination of hardware and software modules in the processor.

Optionally, the above memory 501 may be either independent or integrated with the processor 502. In a case where the memory 501 is arranged independently, the controller 500 further includes a bus for connecting the memory 501 and the processor 502. The bus may be an Industry Standard Architecture (ISA) bus, a Peripheral Component Interconnect (PCI) bus, or an Extended Industry Standard Architecture (EISA) bus, or the like. The bus may be divided into address bus, data bus, control bus, and the like. For ease of presentation, the bus in the drawings of the present disclosure is not limited to only one bus or one type of buses.

A computer-readable storage medium is further provided in an embodiment of the present disclosure. The computer-readable storage medium has computer instructions stored thereon. When the computer instructions are executed by a processor, steps of the method for fault detection of an uninterruptible power supply in any of the above embodiments is implemented.

A computer program product is further provided in an embodiment of the present disclosure. The computer program product includes computer instructions that, when executed by a processor, implement steps of the method for fault detection of an uninterruptible power supply in any of the above embodiments.

Other embodiments of the present disclosure will be apparent to a those skilled in the art from consideration of the specification and practice of the disclosure here. The present disclosure is intended to cover any variation, application, or adapted modification of the present disclosure. Such variation, application, or adapted modification follow the general principles of the present disclosure and include common knowledge or common technical means in the art which are not disclosed in the present disclosure. The description and the embodiments are only illustrative, and the actual scope and spirit of the present disclosure are defined by the claims.

It should be understood that the present disclosure is not limited to the precise structure described above and shown in the drawings. Various modifications and changes may be made without departing from the scope of the present disclosure. The scope of the present disclosure is limited by only the appended claims.

## Claims

1. A method for fault detection of an uninterruptible power supply, which is **characterized in that** the method is applied to an uninterruptible power supply,
the uninterruptible power supply comprises a battery switch device (RLY7-RLY12), a mains power switch device (RLY1-RLY6), and a charger capacitor (C3); an input terminal of the uninterruptible power supply, the mains power switch device (RLY1-RLY6), and a first terminal of the battery switch device (RLY7~RLY12) are electrically connected in series in sequence;
a second terminal of the battery switch device (RLY7~RLY12) is electrically connected to a battery positive access terminal or a battery negative access terminal of the uninterruptible power supply,
the battery positive access terminal is coupled to a first terminal of the charger capacitor (C3), and the battery negative access terminal is coupled to a second terminal of the charger capacitor (C3); and
the method comprises:
acquiring a first voltage difference between a second terminal of the mains power switch device (RLY1~RLY6) and a neutral line (N), before the mains power switch device (RLY1~RLY6) is closed, wherein the second terminal of the mains power switch device (RLY1~RLY6) is electrically connected to the first terminal of the battery switch device (RLY7-RLY12);
acquiring a second voltage difference between the battery positive access terminal and the neutral line (N) when the second terminal of the battery switch device (RLY7~RLY12) is electrically connected to the battery positive access terminal, wherein a voltage value of the battery positive access terminal is a voltage value of a positive electrode of a battery (104) connected to the battery positive access terminal or a voltage value of the first terminal of the charger capacitor (C3);
acquiring a second voltage difference between the battery negative access terminal and the neutral line (N) when the second terminal of the battery switch device (RLY7~RLY12) is electrically connected to the battery negative access terminal, wherein a voltage value of the battery negative access terminal is a voltage value of a negative electrode of a battery (104) connected to the battery negative access terminal or a voltage value of the second terminal of the charger capacitor (C3); and
determining that the battery switch device (RLY7~RLY12) is faulty in a case where an absolute value of a difference between the first voltage difference and the second voltage difference is less than or equal to a first preset voltage difference.

2. The method according to claim 1, wherein the uninterruptible power supply further comprises a precharge circuit and a bus capacitor (C1, C2), and the input terminal of the uninterruptible power supply, the precharge circuit, the bus capacitor (C1, C2) and the neutral line (N) are electrically connected in series; and
before the acquiring a first voltage difference between a second terminal of the mains power switch device (RLY1-R1Y6) and a neutral line (N), the method further comprises:
controlling the precharge circuit to be turned on, enabling the input terminal of the uninterruptible power supply to precharge the bus capacitor (C1, C2).

3. The method according to claim 2, wherein
the uninterruptible power supply further comprises a battery charging circuit (103), a first charging switch device (RLY13) and a second charging switch device (RLY14),
the first charging switch device (RLY13) is electrically connected in series between the battery positive access terminal and the first terminal of the charger capacitor (C3),
the second charging switch device (RLY14) is electrically connected in series between the battery negative access terminal and the second terminal of the charger capacitor (C3),
the charger capacitor (C3) is electrically connected between a first terminal of the battery charging circuit (103) and a second terminal of the battery charging circuit (103), and
the bus capacitor (C1, C2) is electrically connected between a third terminal of the battery charging circuit (103) and a fourth terminal of the battery charging circuit (103); and
before the acquiring a second voltage difference between the battery positive access terminal and the neutral line (N) and the acquiring a second voltage difference between the battery negative access terminal and the neutral line (N), the method further comprises:
acquiring a connection state of a battery (104), wherein the connection state comprises a connected state or an unconnected state; and
controlling the battery charging circuit (103) to charge the charger capacitor (C3) until a voltage difference between two terminals of the charger capacitor (C3) is equal to a third voltage difference, when the battery (104) is in the unconnected state and the voltage difference between the two terminals of the charger capacitor (C3) is less than a second preset voltage difference, and turning on the first charging switch device (RLY13) and the second charging switch device (RLY14) after the charging is completed;
wherein the third voltage difference is greater than or equal to the second preset voltage difference.

4. The method according to claim 3, wherein the third voltage difference is less than a third preset voltage difference, and the third preset voltage difference is determined based on a voltage of a bus (BUS+, BUS-) across which the bus capacitor (C1, C2) is connected.

5. The method according to claim 3 or 4, wherein the acquiring a connection state of a battery (104) comprises:
acquiring a voltage difference between the battery positive access terminal and the battery negative access terminal after the uninterruptible power supply is powered on;
determining that the battery (104) is in an unconnected state in a case where the voltage difference between the battery positive access terminal and the battery negative access terminal is less than the second preset voltage difference; and
determining that the battery (104) is in a connected state in a case where the voltage difference between the battery positive access terminal and the battery negative access terminal is greater than or equal to the second preset voltage difference.

6. The method according to claim 3 or 4, wherein the controlling the battery charging circuit (103) to charge a voltage difference between two terminals of the charger capacitor (C3) to a third voltage difference comprises:
charging the charger capacitor (C3) by the battery charging circuit (103) using electricity stored in the bus capacitor (C1, C2).

7. The method according to any one of claims 1 to 4, wherein after acquiring the second voltage difference, the method further comprises:
closing the mains power switch device (RLY1-R1Y6) of the uninterruptible power supply when the absolute value of the difference between the first voltage difference and the second voltage difference corresponding to each battery switch device (RLY7~RLY12) is greater than the first preset voltage difference, to control the uninterruptible power supply to operate.

8. An apparatus (400) for fault detection of an uninterruptible power supply, which is **characterized by** comprising an acquisition module (401) and a processing module (402), wherein
the acquisition module (401) is configured to acquire a first voltage difference between a second terminal of a mains power switch device (RLY1~RLY6) and a neutral line (N), before the mains power switch device (RLY1-R1Y6) is closed, wherein the mains power switch device (RLY1~RLY6) is located in an uninterruptible power supply, the uninterruptible power supply further comprises a battery switch device (RLY7~RLY12) and a charger capacitor (C3), an input terminal of the uninterruptible power supply is electrically connected to a first terminal of the mains power switch device (RLY1-RLY6), a second terminal of the mains power switch device (RLY1~RLY6) is electrically connected to the battery switch device (RLY7-RLY12), a second terminal of the battery switch device (RLY7~RLY12) is electrically connected to a battery positive access terminal or a battery negative access terminal of the uninterruptible power supply, the battery positive access terminal is coupled to a first terminal of the charger capacitor (C3), and the battery negative access terminal is coupled to a second terminal of the charger capacitor (C3);
the acquisition module (401) is further configured to acquire a second voltage difference between the battery positive access terminal and the neutral line (N) when the second terminal of the battery switch device (RLY7~RLY12) is electrically connected to the battery positive access terminal, wherein a voltage value of the battery positive access terminal is a voltage value of a positive electrode of a battery (104) connected to the battery positive access terminal or a voltage value of the first terminal of the charger capacitor (C3);
the acquisition module (401) is further configured to acquire a second voltage difference between the battery negative access terminal and the neutral line (N) when the second terminal of the battery switch device (RLY7~RLY12) is electrically connected to the battery negative access terminal, wherein a voltage value of the battery negative access terminal is a voltage value of a negative electrode of a battery (104) connected to the battery negative access terminal or a voltage value of the second terminal of the charger capacitor (C3); and
the processing module (402) is configured to determine that the battery switch device (RLY7~RLY12) is faulty in a case where an absolute value of a difference between the first voltage difference and the second voltage difference is less than or equal to a first preset voltage difference.

9. The apparatus according to claim 8, wherein
the processing module is further configured to control a precharge circuit to be turned on before the first voltage difference between the second terminal of the mains power switch device (RLY1~RLY6) and the neutral line (N) is acquired by the acquisition module (401), enabling the input terminal of the uninterruptible power supply to precharge the bus capacitor (C1, C2); and
wherein the uninterruptible power supply further comprises the precharge circuit and the bus capacitor (C 1, C2), and the input terminal of the uninterruptible power supply, the precharge circuit, the bus capacitor (C1, C2) and the neutral line (N) are electrically connected in series.

10. A controller (500), which is **characterized by** comprising a processor (502) and a memory (501) communicatively connected to the processor (502), wherein
the memory (501) stores computer executable instructions; and
the processor (502), when executing the computer executable instructions, is configured to implement the method according to any one of claims 1 to 7.
